# EUROPÄISCHE PATENTANMELDUNG

(11) **EP 4 794 515 A2**
(43) Veröffentlichungstag der Anmeldung: **19.08.2026**
(21) Anmeldenummer: 26153089.3
(22) Anmeldetag: 20.01.2026
(51) Int. Cl.: H10W 90/00, H10W 90/10, H02M 7/00, H02M 7/487

(54) **LEISTUNGSMODUL**

(30) Priorität: 28.01.2025 DE 102025103081
(71) Anmelder: Volkswagen Aktiengesellschaft, 38440 Wolfsburg (DE)
(72) Erfinder: Hartwig, Dr. Raphael, 38440 Wolfsburg (DE); Schiedermeier, Maximilian, 38440 Wolfsburg (DE); Gaona, Dr. Daniel, 38440 Wolfsburg (DE); Bayer, Dr. Christoph Friedrich, 38440 Wolfsburg (DE)

(57) **Zusammenfassung**

Die Erfindung betrifft ein Leistungsmodul (100), wobei das Leistungsmodul (100) einen Träger mit einer Isolationsschicht und mindestens einer strukturierten Metallisierung aufweist, wobei auf der strukturierten Metallisierung mindestens eine Halbbrücke für einen 3-Level T-Type Wechselrichter angeordnet ist, wobei die Halbbrücke mindestens zwei High-Side-Schalter (S_{1U1}, S_{1U2}), mindestens zwei Low-Side-Schalter (S_{2U1}, S_{2U2}) und zwei Mittelpunktschalter (S_{3U}, S_{4U}) aufweist, wobei die High-Side-Schalter (S_{1U1}, S_{1U2}) mit mindestens einem positiven Anschluss (DC+), die Low-Side-Schalter (S_{2U1}, S_{2U2}) mit mindestens einem negativen Anschluss (DC-) und die Mittelpunktschalter (S_{3U}, S_{4U}) mit einem Anschluss (N) für einen Neutralpunkt und einen Anschluss (AC) für den Mittelabgriff verbunden sind, wobei die Mittelpunktschalter (S_{3U}, S_{4U}) in Längsrichtung (L) mittig auf dem Träger angeordnet sind, wobei die High-Side-Schalter (S_{1U1}, S_{1U2}) und die Low-Side-Schalter (S_{2U1}, S_{2U2}) derart angeordnet sind, dass eine parasitäre Induktivität zwischen dem positiven Anschluss (DC+) und dem Anschluss (N) für den Mittelpunkt gleich einer parasitären Induktivität zwischen dem negativen Anschluss (DC-) und dem Anschluss (N) für den Neutralpunkt ist.

## Beschreibung

Die Erfindung betrifft ein Leistungsmodul mit einem Träger mit einer Isolationsschicht und mindestens einer strukturierten Metallisierung, wobei auf der strukturierten Metallisierung mindestens eine Halbbrücke für einen 3-Level T-Type Wechselrichter angeordnet ist.

Bislang sind die Wechselrichter für Elektromaschinen in 2-Level-Topologie aufgebaut, um aus einer Gleichspannung eine dreiphasige Wechselspannung für die Elektromaschine zu generieren. Dabei weist jede Halbbrücke einen High-Side-Schalter und einen Low-Side-Schalter auf, die als Halbleiterschalter ausgebildet sind. In der 2-Level Topologie werden die beiden Halbleiter einer jeden Halbbrücke jeweils zwischen DC+ und DC- geschaltet. Aufgrund der hohen Amplituden der getakteten Spannung und des hohen Stromrippels entstehen in der Elektromaschine Verluste. Diese sind besonders im Teillastbereich kritisch, da die Verluste oftmals abhängig von der Schaltfrequenz sind und nicht von der Leistung. Eine Verbesserung dieser Problematik ist entweder durch eine Erhöhung der Schaltfrequenz möglich oder durch eine Reduktion der Amplitude der geschalteten Spannung. Die Schaltfrequenz kann aufgrund der Schaltverluste nur bedingt erhöht werden, da ansonsten die Verluste im Wechselrichter im Gegensatz zu den Verlusten der Elektromaschine dominieren, sodass der Gesamtwirkungsgrad nahezu gleichbleibt.

Daher befassen sich viele derzeitige Entwicklungen mit einer 3-Level-Topologie, welche die Möglichkeit bietet, die Amplitude der geschalteten Spannung aufgrund eines zusätzlichen Spannungspotentials zu reduzieren. Eine der bekanntesten 3-Level-Topologien ist aufgrund ihrer Performance und dennoch einfachen Ansteuerung die 3-Level T-Type Topologie (in der Literatur ist die T-Type Topologie auch als TNPC-Topologie bekannt) . Der T-Type- bzw. Mittelpunktschalter-Pfad kann zudem geringer ausgelegt werden und nur in Arbeitspunkten mit geringerer Leistung (Teillastbetrieb) genutzt werden. Im Volllastbereich wird dann lediglich ein 2-Level-Betrieb verwendet.

Zur praktischen Umsetzung eines Leistungsmoduls, welches mindestens eine Halbbrücke für einen 3-Level T-Type-Wechselrichter aufweist, kommen Träger zur Anwendung, die eine Isolationsschicht und mindestens eine strukturierte Metallisierung aufweisen. Die Isolationsschicht ist dabei vorzugsweise eine Keramik und die strukturierte Metallisierung ist aus Kupfer oder Aluminium. Derartige Träger sind in verschiedenen Techniken bekannt, z.B. DCB oder IMS.

Ein Problem ist die Anordnung der einzelnen Elemente (Halbleiterschalter) auf dem Träger, die neue Probleme bezüglich des Schaltverhaltens und der Schaltverluste hervorrufen können.

Der Erfindung liegt daher das technische Problem zugrunde, ein Leistungsmodul zu schaffen, wobei das Leistungsmodul mindestens einen Träger aufweist, auf dem mindestens eine Halbbrücke eines 3-Level-T-Types-Wechselrichters angeordnet ist, bei dem Schaltverhalten und Schaltverluste verbessert sind.

Die Lösung des technischen Problems ergibt sich durch ein Leistungsmodul mit den Merkmalen des Anspruchs 1. Weitere vorteilhafte Ausgestaltungen der Erfindung ergeben sich aus den Unteransprüchen.

Das Leistungsmodul weist einen Träger mit einer Isolationsschicht und mindestens einer strukturierten Metallisierung auf. Auf der strukturierten Metallisierung ist mindestens eine Halbbrücke für einen 3-Level T-Type Wechselrichter angeordnet. Die Halbbrücke weist mindestens zwei High-Side-Schalter, mindestens zwei Low-Side-Schalter und zwei Mittelpunktschalter auf. Die High-Side-Schalter sind mit mindestens einem positiven Anschluss verbunden. Die Low-Side-Schalter sind mit mindestens einem negativen Anschluss verbunden. Die Mittelpunktschalter sind an einem Ende mit einem Anschluss für einen Neutralpunkt und an dem anderen Ende mit einem Anschluss für den Mittelabgriff verbunden. Die Mittelpunktschalter sind in Längsrichtung mittig auf dem Träger angeordnet, wobei die High-Side-Schalter derart angeordnet sind, dass eine parasitäre Induktivität zwischen dem positiven Anschluss und dem Anschluss für den Neutralpunkt gleich einer parasitären Induktivität zwischen negativem Anschluss und dem Anschluss für den Neutralpunkt ist. Gleich bedeutet dabei unter Berücksichtigung der Toleranzen, dass die Abweichung kleiner 10 % ist. Dadurch ergibt sich ein sehr symmetrisches Schaltverhalten. Dabei wird weiter angestrebt, den Absolutwert der parasitären Induktivitäten möglichst gering zu halten.

Die Isolationsschicht ist vorzugsweise eine Keramik. Dabei kann unterhalb der Isolationsschicht (also auf der der strukturierten Metallisierung gegenüberliegenden Seite) eine weitere Metallisierung angeordnet sein, über die das Leistungsmodul thermisch an einen Kühlkörper angebunden werden kann. Vorzugsweise ist das Leistungsmodul mit einer Vergussmasse vergossen oder mit einem Transfermold gemoldet.

Die Mittelpunktschalter sind als anti-seriell verschaltete MOSFETs oder als GaN-BIDFETs ausgebildet, um den Strom in beiden Richtungen sperren zu können.

In einer weiteren Ausführungsform ist ein gemeinsamer Gate-Anschluss symmetrisch zu den High-Side-Schalten und ein gemeinsamer Gate-Anschluss symmetrisch zu den Low-Side-Schaltern angeordnet, sodass die jeweiligen High-Side-Schalter und die jeweiligen Low-Side-Schalter synchron schalten, wobei jeweils nur ein einfacher Gate-Treiber benötigt wird (also keine Einzel-Gate-Ansteuerung).

In einer weiteren Ausführungsform weist die Halbbrückenschaltung vier High-Side-Schalter und vier Low-Side-Schalter auf. Dabei sind jeweils zwei High-Side-Schalter und zwei Low-Side-Schalter oberhalb und unterhalb der Mittelpunktschalter in Längsrichtung angeordnet. Dabei sind die High-Side-Schalter oberhalb der Mittelpunktschalter mit einem ersten positiven Anschluss und die High-Side-Schalter unterhalb der Mittelpunktschalter mit einem zweiten positiven Anschluss verbunden. Entsprechend sind die Low-Side-Schalter oberhalb der Mittelpunktschalter mit einem ersten negativen Anschluss und die Low-Side-Schalter unterhalb der Mittelpunktschalter mit einem zweiten negativen Anschluss verbunden. Durch die wechselweise Anordnung der Anschlüsse wird ein sehr niederinduktiver Aufbau realisiert.

In einer weiteren Ausführungsform ist dabei ein gemeinsamer Gate-Anschluss für die High-Side-Schalter oberhalb der Mittelpunktschalter spiegelsymmetrisch zu einem gemeinsamen Gate-Anschluss für die High-Side-Schalter unterhalb der Mittelpunktschalter. Entsprechend ist ein gemeinsamer Gate-Anschluss für die Low-Side-Schalter oberhalb der Mittelpunktschalter spiegelsymmetrisch zu einem gemeinsamen Gate-Anschluss für die Low-Side-Schalter unterhalb der Mittelpunktschalter angeordnet. Dabei verläuft die gemeinsame Spiegelachse horizontal durch die Mittelpunktschalter. Hierdurch wird wieder das Schaltverhalten der High-Side-Schalter bzw. der Low-Side-Schalter synchronisiert.

In einer alternativen Ausführungsform weist die Halbbrückenschaltung vier High-Side-Schalter und vier Low-Side-Schalter auf, wobei jeweils zwei High-Side-Schalter und jeweils zwei Low-Side-Schalter oberhalb und unterhalb der Mittelpunktschalter in Längsrichtung angeordnet sind, wobei die High-Side-Schalter mit einem positiven Anschluss verbunden sind, wobei die Low-Side-Schalter oberhalb der Mittelpunktschalter mit einem ersten negativen Anschluss und die Low-Side-Schalter unterhalb der Mittelpunktschalter mit einem zweiten negativen Anschluss verbunden sind, wobei ein Anschluss für den Neutralpunkt hinter dem positiven Anschluss angeordnet ist. Hierdurch können die Anschlüsse breiter ausgeführt werden, wobei die Kontaktierung des Neutralpunktes vorzugsweise höhenversetzt zu den anderen Anschlüssen erfolgt. Dabei kann das Prinzip auch vertauscht werden, sodass ein zentraler negativer Anschluss existiert und zwei Anschlüsse für den positiven Anschluss.

In einer weiteren alternativen Ausführungsform sind jeweils mindestens ein High-Side-Schalter und mindestens ein Low-Side-Schalter oberhalb der Mittelpunktschalter und jeweils mindestens ein High-Side-Schalter und mindestens ein Low-Side-Schalter unterhalb der Mittelpunktschalter angeordnet, wobei der mindestens eine High-Side-Schalter oberhalb der Mittelpunktschalter mit einem ersten positiven Anschluss und der mindestens eine High-Side-Schalter unterhalb der Mittelpunktschalter mit einem zweiten positiven Anschluss verbunden sind, wobei der mindestens eine Low-Side-Schalter oberhalb der Mittelpunktschalter mit einem ersten negativen Anschluss und der mindestens eine Low-Side-Schalter unterhalb der Mittelpunktschalter mit einem zweiten negativen Anschluss verbunden ist. Auch hierdurch wird die resultierende Induktivität reduziert. Vorzugsweise sind die Source-Anschlüsse der High-Side-Schalter über einen metallischen Clip miteinander verbunden, wobei der Clip eine Doppel-T-Struktur aufweist, über die der Clip den Anschluss für den Mittelabgriff, die beiden Drain-Anschlüsse der Low-Side-Schalter und einen Anschluss der Mittelpunktschalter kontaktiert.

Alternativ sind die Source-Anschlüsse der High-Side-Schalter jeweils über einen Clip mit dem Drain-Anschluss eines Low-Side-Schalters und einer Metallisierung für einen Anschluss für den Mittelabgriff verbunden, wobei über einen weiteren Clip ein Anschluss der Mittelpunktschalter mit dem Anschluss für den Mittelabgriff verbunden ist.

Vorzugsweise weist dabei der weitere Clip eine Aussparung auf, wobei unterhalb der Aussparung ein gemeinsamer Gate-Anschluss für die High-Side-Schalter angeordnet ist.

Die Erfindung wird nachfolgend anhand bevorzugter Ausführungsbeispiele näher erläutert. Die Figuren zeigen:
- Fig. 1: eine schematische Darstellung eines 3-Level-T-Type-Wechselrichters in einer Common-Drain Ausbildung mit anti-seriellen MOSFETs,
- Fig. 2a: eine schematische Darstellung einer 3-Level-T-Type-Halbbrücke mit zwei High-Side- und zwei Low-Side-Schaltern,
- Fig. 2b: ein Leistungsmodul mit einer Schaltung gemäß Fig. 2a,
- Fig. 3: ein alternatives Leistungsmodul mit einer Schaltung gemäß Fig. 2a,
- Fig. 4: ein weiteres alternatives Leistungsmodul,
- Fig. 5: ein weiteres alternatives Leistungsmodul,
- Fig. 6a: eine Schaltungsanordnung mit acht parallelen High-Side- und acht parallelen Low-Side-Schaltern,
- Fig. 6b: ein Leistungsmodul mit einer Schaltungsanordnung gemäß Fig. 6a,
- Fig. 7a: eine Schaltungsanordnung mit vier parallelen High-Side- und vier parallelen Low-Side-Schaltern,
- Fig. 7b: ein Schaltungsmodul mit einer Schaltungsanordnung gemäß Fig. 7a,
- Fig. 7c: eine Draufsicht auf ein mit einer Vergussmasse vergossenes Leistungsmodul gemäß Fig. 7b,
- Fig. 7d: eine Seitenansicht auf ein Leistungsmodul gemäß Fig. 7c,
- Fig. 8a: eine Schaltungsanordnung mit vier parallelen High-Side- und vier parallelen Low-Side-Schaltern,
- Fig. 8b: ein Leistungsmodul mit einer Schaltungsanordnung gemäß Fig. 8a mit versetztem Anschluss N für einen Neutralpunkt,
- Fig. 8c: eine Draufsicht auf ein mit einer Vergussmasse vergossenes Leistungsmodul gemäß Fig. 8b,
- Fig. 8d: eine Seitenansicht auf ein Leistungsmodul gemäß Fig. 8c,
- Fig. 9a: eine Schaltungsanordnung mit zwei parallelen High-Side- und zwei parallelen Low-Side-Schaltern mit anti-seriell verschalteten MOSFET in Common-Source,
- Fig. 9b: ein Leistungsmodul mit einer Schaltungsanordnung gemäß Fig. 9a,
- Fig. 10a: eine Schaltungsanordnung mit zwei parallelen High-Side- und zwei parallelen Low-Side-Schaltern und einem GaN-BIDFET als Mittelpunktschalter und
- Fig. 10b: ein Leistungsmodul mit einer Schaltungsanordnung gemäß Fig. 10a.

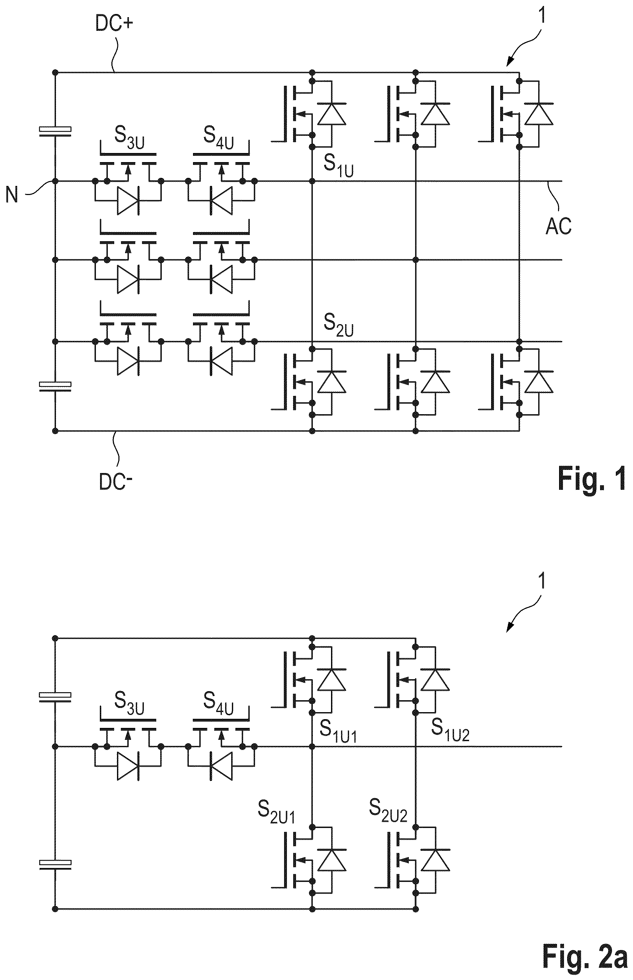

**In der** **Fig.** 1 ist eine Schaltung 1 eines 3-Level-T-Type-Wechselrichters mit drei Halbbrücken dargestellt. Eine erste Halbbrücke weist einen High-Side-Schalter S_{1U} und einen Low-Side-Schalter S_{2U} auf, die beispielsweise als Si- oder SiC-MOSFETs ausgebildet sind, deren intrinsische Diode jeweils eine Freilaufdiode ausbildet. Weiter sind zwei Mittelpunktschalter S_{3U}, S_{4U} dargestellt, die antiseriell in Common-Drain-Verschaltung sind. Der Source-Anschluss von dem Mittelpunktschalter S_{3U} ist mit einem Neutralpunkt N der Schaltung 1 verbunden, wohingegen der Source-Anschluss des anderen Mittelpunktschalters S_{4U} einen Anschluss AC für eine Wechselspannung bildet. Der Anschluss AC für die Wechselspannung ist gleichzeitig mit einem Mittelabgriff zwischen dem High-Side-Schalter S_{1U} und dem Low-Side-Schalter S_{2U} verbunden

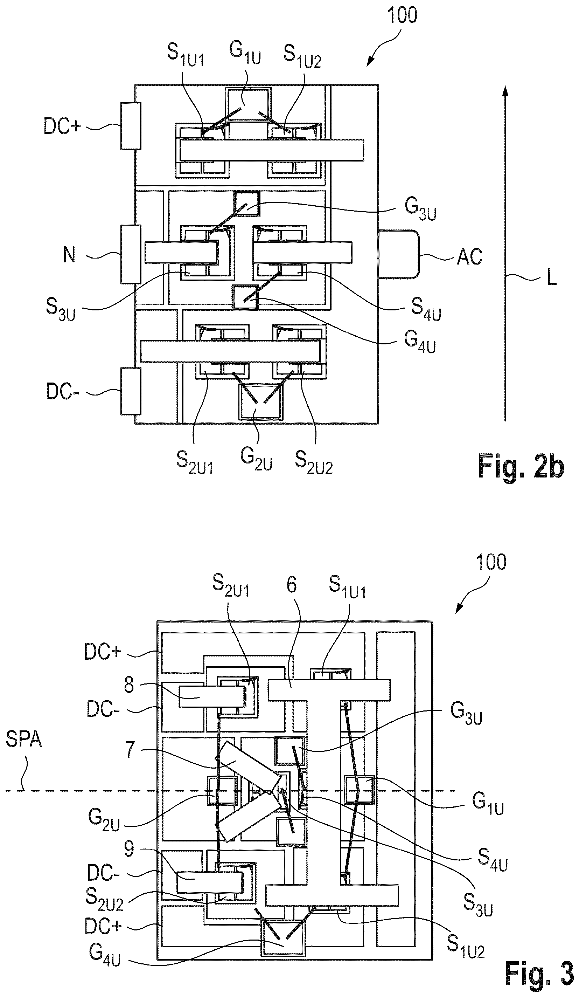

Nachfolgend werden nun verschiedene Ausführungsformen dargestellt, wie diese Schaltung 1 in verschiedenen Varianten in einem Leistungsmodul 100 umgesetzt werden kann, wobei Schaltzeiten und Synchronität optimiert sind. **In** Fig. 2a und Fig. 2b ist eine Schaltung 1 für eine Halbbrücke dargestellt, wobei zwei High-Side-Schalter S_{1U1}, S_{1U2} sowie zwei Low-Side-Schalter S_{2U1}, S_{2U2} parallel geschaltet sind, um die begrenzte Stromtragfähigkeit zu kompensieren. Dabei ist in Fig. 2b das Layout des Leistungsmoduls 100 dargestellt. Dabei sind die beiden High-Side-Schalter S_{1U1}, S_{1U2} in Längsrichtung L oberhalb der beiden Mittelpunktschalter S_{3U}, S_{4U} angeordnet, wobei ein gemeinsamer Gate-Anschluss G_{1U} symmetrisch zu den beiden Gates der High-Side-Schalter S_{1U1}, S_{1U2} angeordnet ist. Die Verbindung zwischen den Gates und dem Gate-Anschluss G_{1U} erfolgt über Bonddrähte. Die Drain-Anschlüsse der beiden High-Side-Schalter sind über die strukturierte Metallisierung des Trägers verbunden, wobei die beiden Source-Anschlüsse über ein Leadframe 2 mit einer Metallisierung für den Anschluss AC der Wechselspannung verbunden sind. Bei den Low-Side-Schaltern S_{2U1}, S_{2U2} sind die Drain-Anschlüsse über die Metallisierung des Trägers mit dem Anschluss AC verbunden, wohingegen die Source-Anschlüsse über ein Leadframe 3 mit dem Anschluss DC- für eine negative Gleichspannung verbunden sind. Der Source-Anschluss des einen Mittelpunktschalters S_{3U} ist über ein Leadframe 4 mit dem Anschluss N und der Source-Anschluss des anderen Mittelpunktschalters S_{4U} ist über ein Leadframe 5 mit dem Anschluss AC verbunden (genauer mit deren strukturierten Metallisierungen auf dem Träger). Anstelle von Leadframes 2-5 können auch Ribbon-Bonds oder Clips verwendet werden, die vorzugsweise ein ähnliches elektrisches Verhalten wie die strukturierte Metallisierung auf dem Träger aufweisen. Dadurch haben die beiden High-Side-Schalter S_{1U1}, S_{1U2} nahezu identische Leistungspfade, da zwar der Pfad des ersten High-Side-Schalters S_{1U1} auf der Metallisierung zu DC+ kürzer ist, dafür aber im Leadframe 2 länger ist und umgekehrt. Haben Leadframe 2 und Metallisierung ein gleiches elektrisches Verhalten, so gleicht sich dies aus. Gleiches gilt für die Low-Side-Schalter. Dabei ist die parasitäre Induktivität für beide Pfade (High-Side und Low-Side) gleich und sehr gering. Dies bleibt auch so, wenn mehr als zwei High-Side- und Low-Side-Schalter parallel geschaltet sind. Durch die symmetrische Anordnung der Gate-Anschlüsse G_{1U}, G_{2U}, G_{3U}, G_{4U} ist das Schaltverhalten synchronisiert, wodurch Oszillationen vermieden werden.

In der Fig. 3 ist eine alternative Umsetzung der Schaltung 1 gemäß Fig. 2a in einem Leistungsmodul 100 dargestellt. Dabei sind die beiden Mittelpunktschalter S_{3U}, S_{4U} wieder mittig angeordnet, wobei jeweils ein High-Side-Schalter S_{1U1} und ein Low-Side-Schalter S_{2U1} oberhalb der Mittelpunktschalter S_{3U}, S_{4U} angeordnet ist (bezogen auf die Längsrichtung L, siehe auch Fig. 2b) und jeweils ein High-Side-Schalter S_{1U2} und ein Low-Side-Schalter S_{2U2} unterhalb der Mittelpunktschalter S_{3U}, S_{4U} angeordnet ist. Das Leistungsmodul 100 weist dabei zwei Anschlüsse DC+ für eine positive Gleichspannung und zwei Anschlüsse DC- für eine negative Gleichspannung auf. Die Gate-Anschlüsse G_{1U}, G_{2U}, G_{3U}, G_{4U} sind wieder symmetrisch angeordnet. Die Source-Anschlüsse der High-Side-Schalter S_{1U1}, S_{1U2} sind über einen Clip mit Doppel-T-Struktur 6 mit dem Source-Anschluss des Mittelpunktschalters S_{4U} und der Metallisierung für den Anschluss AC verbunden. Der Source-Kontakt des Mittelpunktschalters S_{3U} ist über eine V-ähnliche Struktur 7 mit der Metallisierung des Anschlusses N verbunden, wobei der Gate-Anschluss G_{3U} auf einer eigenen Metallisierung angeordnet ist, die durch Isolationsgräben getrennt ist. Über Kontakte 8, 9 sind die Source-Anschlüsse der Low-Side-Schalter S_{2U1}, S_{2U2} jeweils mit einem Anschluss DC- für die negative Gleichspannung verbunden. Die Doppel-T-Schalter 6, die V-ähnliche Struktur 7 und die beiden Kontakte 8, 9 können wieder als Leadframes, Ribben Bonds oder Clips ausgebildet sein. Der Vorteil dieser Anordnung gegenüber der von Fig. 2b ist, dass der gesamte Aufbau spiegelsymmetrisch zu einer Spiegelachse SPA ist, die horizontal durch das Leistungsmodul 100 verläuft. Durch die Aufteilung der Anschlüsse DC+, DC- für die Gleichspannung ist der Aufbau niederinduktiv.

Weiter ist durch den Aufbau die Symmetrie weiter verbessert, sodass die beiden High-Side-Schalter S_{1U1}, S_{1U2} identische Kommutierungskreisinduktivitäten aufweisen.

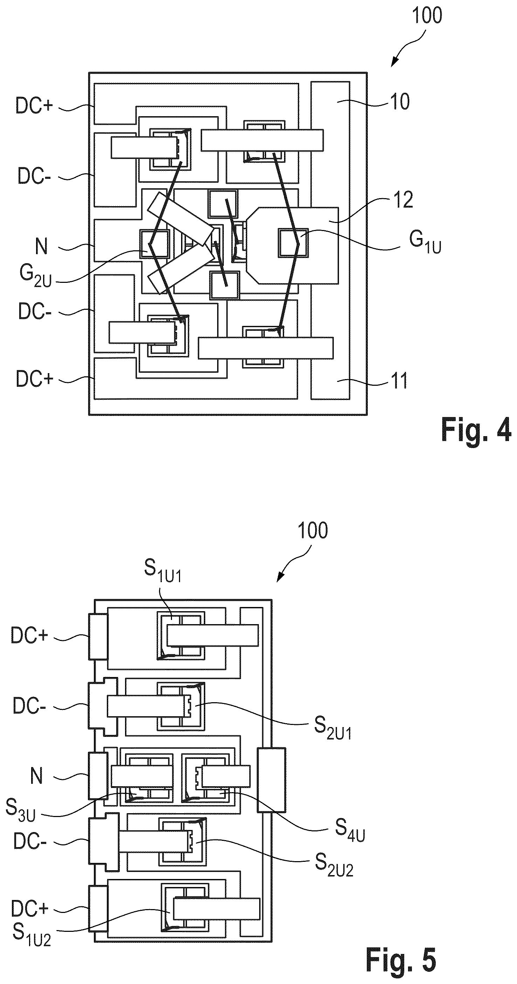

In der Fig. 4 ist eine leichte Modifizierung der Ausführungsform gemäß Fig. 3 dargestellt. Der einzige Unterschied ist, dass die große Doppel-T-Struktur 6 durch drei einzelne Kontakte 10-12 in Form von Clips ersetzt wird, wobei in dem Kontakt 12 eine Aussparung ist, unter der der Gate-Anschluss G_{1U} für die High-Side-Schalter S_{1U1}, S_{1U2} angeordnet ist. Die Kontakte 10-12 können wieder als Leadframes oder Clips ausgebildet sein. Auch dieses Design ist spiegelsymmetrisch zur Spiegelachse SPA (siehe Fig. 3). Der Vorteil ist die etwas einfachere Handhabbarkeit der kleineren Kontakte 10-12, wobei jedoch die Kommutierungskreisinduktivität leicht erhöht ist.

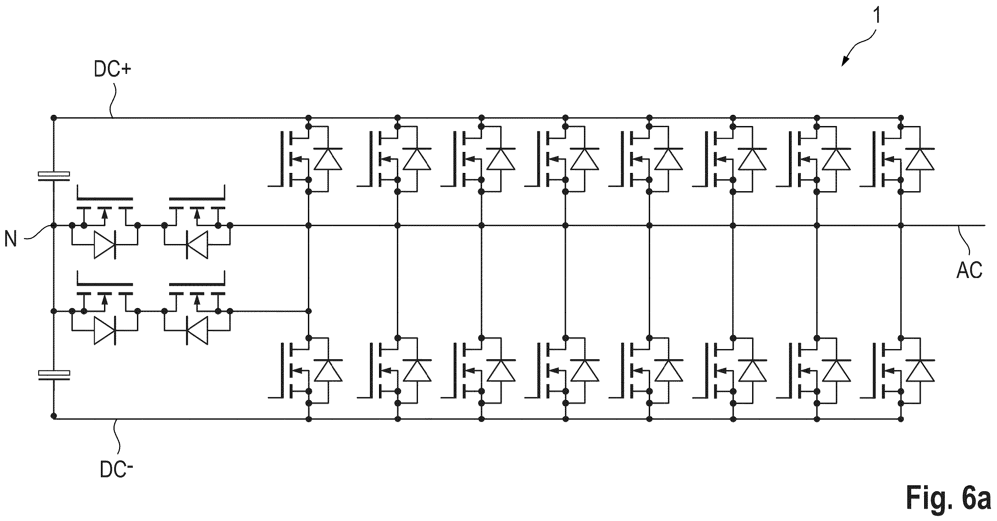

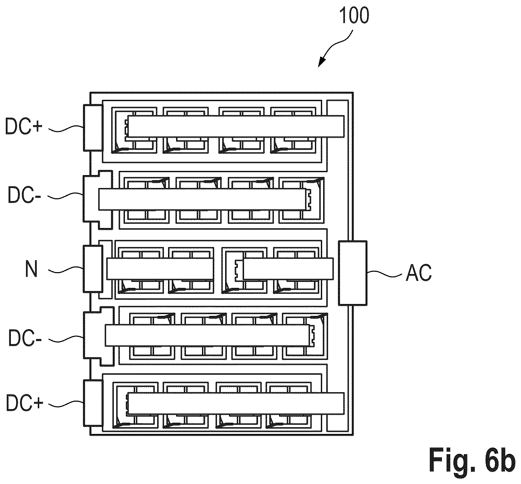

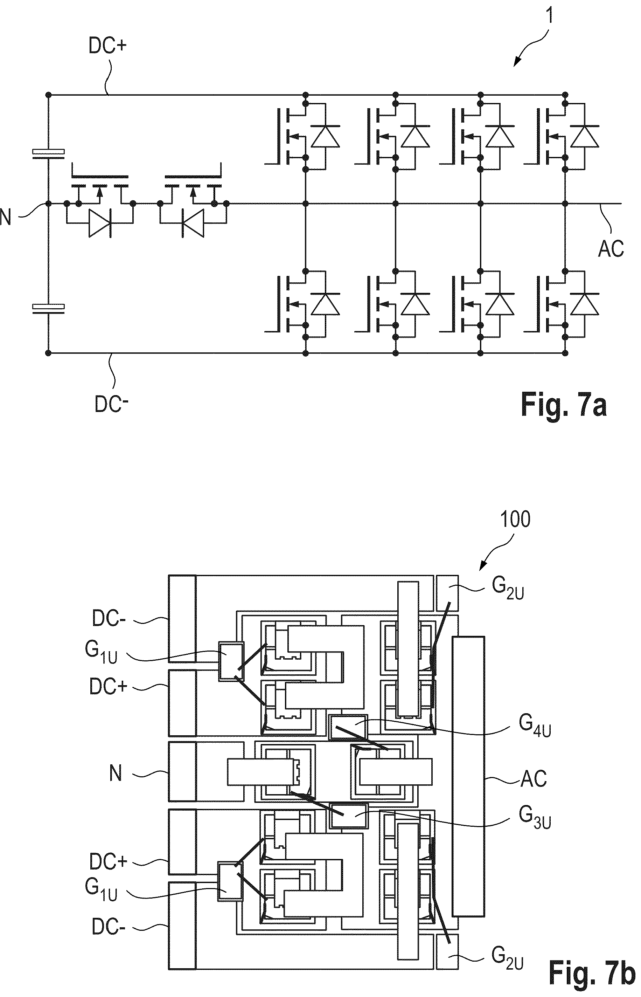

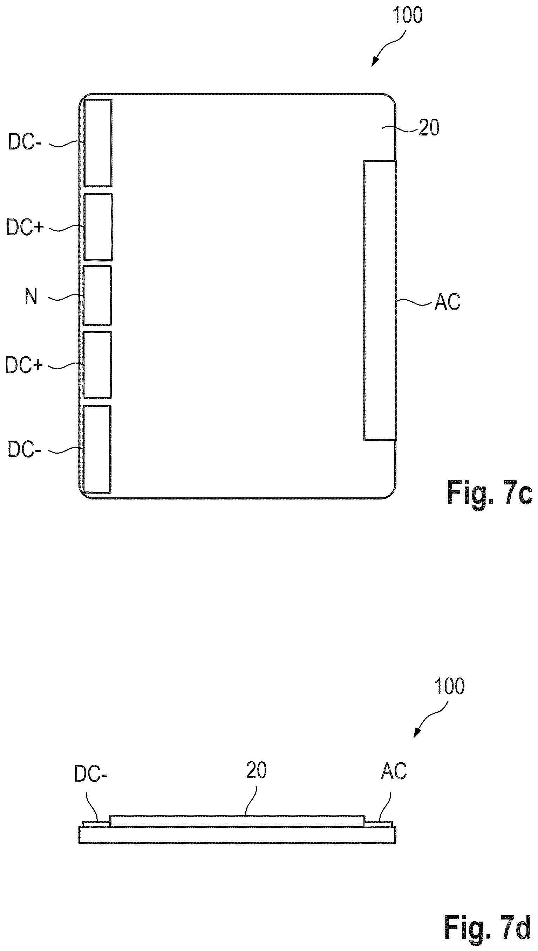

In der Fig. 5 ist eine weitere alternative Ausführungsform eines Leistungsmoduls 100 dargestellt, die eine Kombination der vorangegangenen Ausführungsformen ist. Auch diese Ausführungsform ist spiegelsymmetrisch zur Spiegelachse SPA (siehe Fig. 3). Nicht dargestellt sind die Gate-Anschlüsse, die aber geeignet symmetrisch verteilt werden können. Die Kontakte zwischen den Source-Anschlüssen und den Anschlüssen DC+, DC-, **N,** AC können wieder Leadframes, Clips oder Ribben Bonds sein. Dieses Design ist auch leicht skalierbar für mehr als zwei parallele High-Side- und Low-Side-Schalter, indem weitere Schalter in X-Richtung hinzugefügt werden (die X-Achse ist gleich der Spiegelachse SPA). Dies ist in Fig. 6b für acht High-Side-Schalter und acht Low-Side-Schalter dargestellt, wobei parallel zu den Mittelpunktschaltern zwei weitere Mittelpunktschalter angeordnet sind, wobei deren Mittelabgriffe miteinander verbunden sind (sieh auch Fig. 6a). Wie in Fig. 5 wurde auf die Darstellung und Anordnung der Gate-Anschlüsse verzichtet. Wie in Fig. 5 ist auch das Leistungsmodul 100 gemäß Fig. 6b spiegelsymmetrisch zur Spiegelachse SPA. In den Fig. 7a bis 7d ist eine weitere Ausführungsform dargestellt, die eine Weiterentwicklung der Ausführungsform gemäß Fig. 3 ist, wobei jeweils vier High-Side-Schalter und jeweils vier Low-Side-Schalter parallel geschaltet sind. Das Leistungsmodul 100 ist wieder spiegelsymmetrisch zur Spiegelachse SPA. Dabei ist zur besseren Orientierung einzelnen Metallflächen der strukturierten Metallisierung ein S für Source und ein D für Drain zugeordnet. Weiter dargestellt sind die Gate-Anschlüsse G_{1U} und G_{2U}, die über Bonddrähte kontaktiert sind. Dabei sind zwar Gate-Anschlüsse G_{2U} symmetrisch angeordnet, allerdings ist der Gate-Stromverlauf in der dargestellten Ausführungsform für die beiden Low-Side-Transistoren oben bzw. unten nicht vollständig symmetrisch. Dies kann aber dadurch erreicht werden, dass über eine erste Verbindung die jeweiligen beiden Gates über eine erste Verbindung miteinander verbunden werden und diese dann mittig über einen Bonddraht mit dem Gate-Anschluss G_{2U} verbunden **werden. Weiter** sind die Gate-Anschlüsse G_{3U}, G_{4U} für die Mittelpunktschalter S_{3U}, S_{4U} dargestellt. In der Fig. 7c ist dann das mit einer Vergussmasse 20 vergossene Leistungsmodul 100 in einer Draufsicht (siehe Fig. 7c) bzw. Seitenansicht (siehe Fig. 7d) dargestellt.

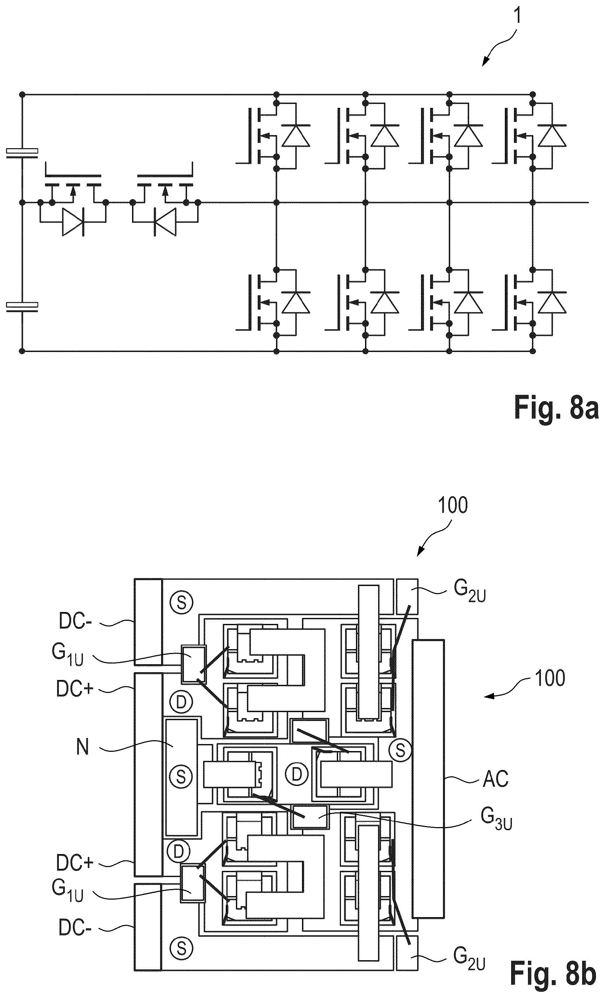

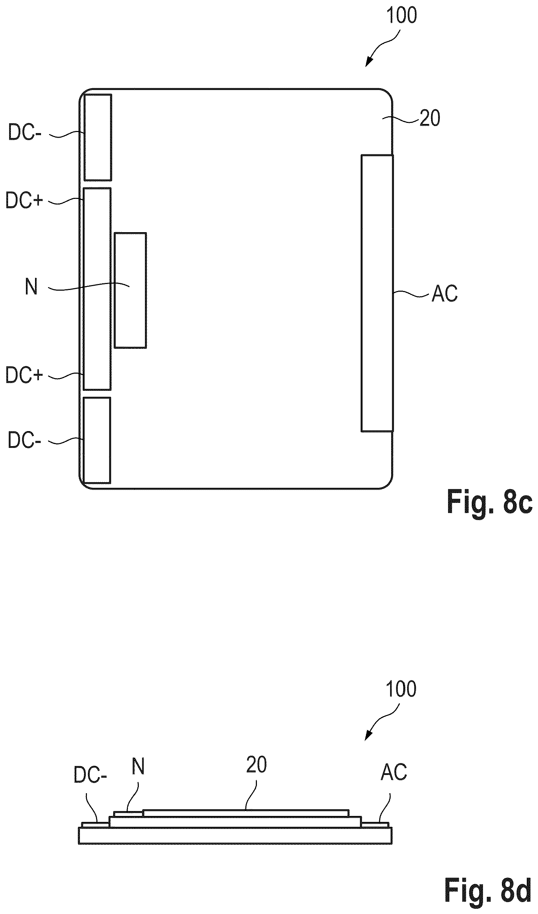

In den Fig. 8a bis 8d ist eine leicht modifizierte Ausführungsform gemäß den Fig. 7a bis 7d dargestellt. Der wesentliche Unterschied ist, dass der Anschluss N für den Neutralpunkt nach innen versetzt ist und etwas höher ist als der benachbarte Anschluss DC+ für die positive Gleichspannung, wobei im Gegensatz zu Fig. 7a bis 7d der Anschluss D+ nicht zweigeteilt ist, sondern ein großer Anschluss ist. Hierdurch wird ein sehr niederinduktives Design ermöglicht.

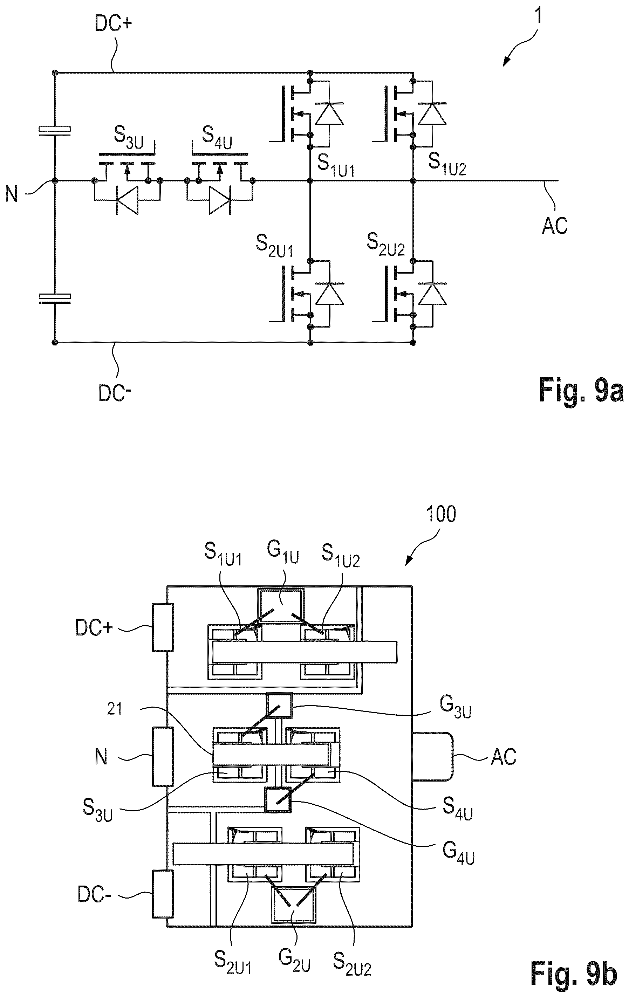

Die bisher dargestellten Ausführungsbeispiele hatten jeweils als Mittelpunktschalter zwei anti-seriell verschaltete MOSFETs mit einem Common-Drain-Ansatz. Die dargestellten Beispiele können jedoch ohne weiteres auch mit einem Common-Source-Ansatz ausgeführt werden, was in Fig. 9a und Fig. 9b für die Ausführungsform gemäß Fig. 2 dargestellt ist. Die Verschaltung für die High-Side- und Low-Side-Schalter ist unverändert, wohingegen die beiden Source-Anschlüsse der Mittelpunktschalter S_{3U}, S_{4U} über ein Clip 21 oder Leadframe miteinander verbunden sind, wobei an der Drain-Metallisierung von S_{3U} der Anschluss N für den Neutralpunkt ist und an der Drain-Metallisierung von S_{4U} der Anschluss AC für den Mittelabgriff ist.

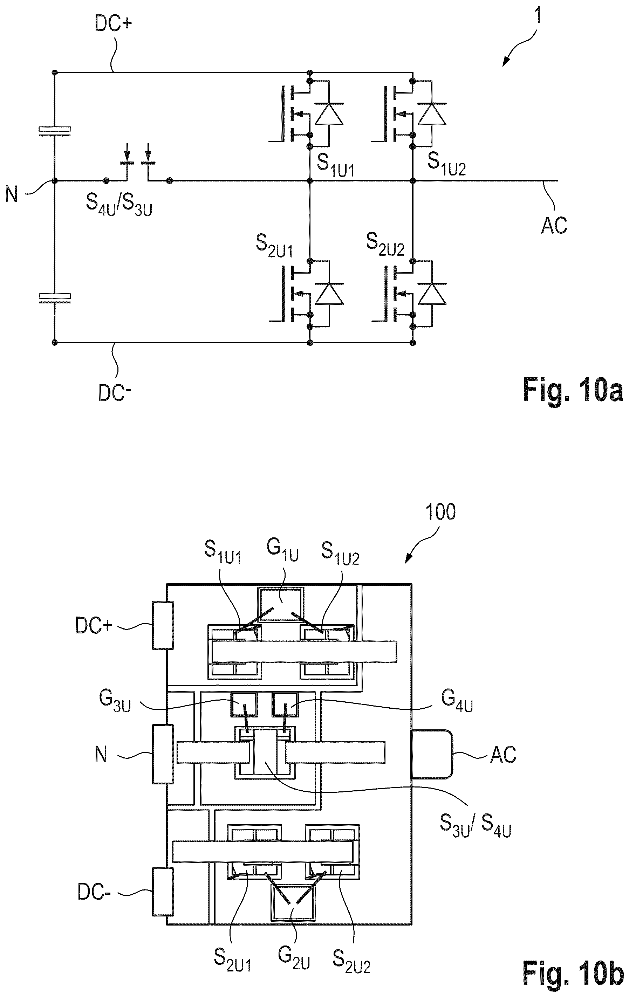

In der Fig. 10a und Fig. 10b ist eine weitere alternative Ausführungsform gemäß Fig. 2 dargestellt. Dabei ist die anti-serielle Verschaltung der MOSFETs als Mittelpunktschalter S_{U3}, S_{U4} durch einen GaN-BIDFET S_{4U}/S_{3U} ersetzt. Der Vorteil derartiger GaN-BIDFETs ist, dass diese quasi nur einen planaren Strom führen und im unteren Leistungsbereich geringe Verluste aufweisen. Wie bereits zuvor erläutert, wird der 3-Level-Betrieb vorzugsweise nur im TeillastBetrieb durchgeführt, wobei im Volllast-Betrieb nur ein 2-Level-Betrieb durchgeführt wird und die Mittelpunktschalter gesperrt werden. Vorzugsweise werden dabei die High-Side-Schalter und die Low-Side-Schalter im 2-Level-Betrieb mit anderen Gate-Widerständen angesteuert als im 3-Level-Betrieb, da sich die Induktivitäten der Kommutierungskreise von 2-Level-Betrieb und 3-Level-Betrieb stark unterscheiden. Die Ausführungsformen mit den GaN-BIDFETs S_{4U}/S_{3U} kann entsprechend auch auf die anderen Ausführungsbeispiele gemäß Fig. 3 bis Fig. 8 angewendet werden.

### Bezugszeichenliste

- 1: Schaltung
- 2: Leadframe
- 3: Leadframe
- 4: Leadframe
- 5: Leadframe
- 6: Doppel-T-Struktur
- 7: V-ähnliche Struktur
- 8: Kontakt
- 9: Kontakt
- 10: Kontakt
- 11: Kontakt
- 12: Kontakt
- 20: Vergussmasse
- 21: Clip
- 100: Leistungsmodul

## Patentansprüche

1. **Leistungsmodul** (100), wobei das Leistungsmodul (100) einen Träger mit einer Isolationsschicht und mindestens einer strukturierten Metallisierung aufweist, wobei auf der strukturierten Metallisierung mindestens eine Halbbrücke für einen 3-Level T-Type Wechselrichter angeordnet ist, wobei die Halbbrücke mindestens zwei High-Side-Schalter (S_{1U1}, S_{1U2}), mindestens zwei Low-Side-Schalter (S_{2U1}, S_{2U2}) und zwei Mittelpunktschalter (S_{3U}, S_{4U}) aufweist, wobei die High-Side-Schalter (S_{1U1}, S_{1U2}) mit mindestens einem positiven Anschluss (DC+), die Low-Side-Schalter (S_{2U1}, S_{2U2}) mit mindestens einem negativen Anschluss (DC-) und die Mittelpunktschalter (S_{3U}, S_{4U}) mit einem Anschluss (N) für einen Neutralpunkt und einen Anschluss (AC) für den Mittelabgriff verbunden sind, wobei die Mittelpunktschalter (S_{3U}, S_{4U}) in Längsrichtung (L) mittig auf dem Träger angeordnet sind, wobei die High-Side-Schalter (S_{1U1}, S_{1U2}) und die Low-Side-Schalter (S_{2U1}, S_{2U2}) derart angeordnet sind, dass eine parasitäre Induktivität zwischen dem positiven Anschluss (DC+) und dem Anschluss (N) für den Mittelpunkt gleich einer parasitären Induktivität zwischen dem negativen Anschluss (DC-) und dem Anschluss (N) für den Neutralpunkt ist.

2. Leistungsmodul (100) nach Anspruch 1, **dadurch gekennzeichnet, dass** die Mittelpunktschalter (S_{3U}, S_{4U}) als anti-seriell verschaltete MOSFETs oder als GaN-BIDFETs (S_{4U}/S_{3U}) ausgebildet sind.

3. Leistungsmodul (100) nach Anspruch 1 oder 2, **dadurch gekennzeichnet, dass** ein gemeinsamer Gate-Anschluss (G_{1U}) symmetrisch zu den High-Side-Schaltern (S_{1U1}, S_{1U2}) und ein gemeinsamer Gate-Anschluss (G_{2U}) symmetrisch zu den Low-Side-Schaltern (S_{2U1}, S_{2U2}) angeordnet ist.

4. Leistungsmodul (100) nach einem der vorangegangenen Ansprüchen, **dadurch gekennzeichnet, dass** die Halbbrückenschaltung vier High-Side-Schalter und vier Low-Side-Schalter aufweist, wobei jeweils zwei High-Side-Schalter und zwei Low-Side-Schalter oberhalb und unterhalb der Mittelpunktschalter (S_{3U}, S_{4U}) in Längsrichtung (L) angeordnet sind, wobei die High-Side-Schalter oberhalb der Mittelpunktschalter (S_{3U}, S_{4U}) mit einem ersten positiven Anschluss (DC+) und die High-Side-Schalter unterhalb der Mittelpunktschalter (S_{3U}, S_{4U}) mit einem zweiten positiven Anschluss DC+) verbunden **sind, wobei** die Low-Side-Schalter oberhalb der Mittelpunktschalter (S_{3U}, S_{4U}) mit einem ersten negativen Anschluss (DC-) und die Low-Side-Schalter unterhalb der Mittelpunktschalter (S_{3U}, S_{4U}) mit einem zweiten negativen Anschluss (DC-) verbunden sind.,

5. Leistungsmodul (100) nach Anspruch 4, **dadurch gekennzeichnet, dass** ein gemeinsamer Gate-Anschluss (G_{1U}) für die High-Side-Schalter oberhalb der Mittelpunktschalter (S_{3U}, S_{4U}) spiegelsymmetrisch zu einem gemeinsamen Gate-Anschluss (G_{1U}) für die High-Side-Schalter unterhalb der Mittelpunktschalter (S_{3U}, S_{4U}) ist und ein gemeinsamer Gate-Anschluss (G_{2U}) für die Low-Side-Schalter oberhalb der Mittelpunktschalter (S_{3U}, S_{4U}) spiegelsymmetrisch zu einem gemeinsamen Gate-Anschluss (G_{2U}) für die Low-Side-Schalter unterhalb der Mittelpunktschalter (S_{3U}, S_{4U}) ist, wobei die gemeinsame Spiegelachse (SPA) horizontal durch die Mittelpunktschalter (S_{3U}, S_{4U}) verläuft.

6. Leistungsmodul (100) nach einem der Ansprüche 1 bis 3, **dadurch gekennzeichnet, dass** die Halbbrückenschaltung vier High-Side-Schalter und vier Low-Side-Schalter aufweist, wobei jeweils zwei High-Side-Schalter und jeweils zwei Low-Side-Schalter oberhalb und unterhalb der Mittelpunktschalter (S_{3U}, S_{4U}) in Längsrichtung (L) angeordnet sind, wobei die High-Side-Schalter mit einem positiven Anschluss (DC+) verbunden sind, wobei die Low-Side-Schalter oberhalb der Mittelpunktschalter mit einem ersten negativen Anschluss (DC-) und die Low-Side-Schalter unterhalb der Mittelpunktschalter (S_{3U}, S_{4U}) mit einem zweiten negativen Anschluss (DC-) verbunden sind, wobei ein Anschluss (N) für den Neutralpunkt hinter dem positiven Anschluss (DC+) angeordnet ist.

7. Leistungsmodul (100) nach einem der Ansprüche 1 bis 3, **dadurch gekennzeichnet, dass** jeweils mindestens ein High-Side-Schalter (S_{1U1}) und mindestens ein Low-Side-Schalter (S_{2U1}) oberhalb der Mittelpunktschalter (S_{3U}, S_{4U}) und jeweils mindestens ein High-Side-Schalter (S_{1U2}) und mindestens ein Low-Side-Schalter (S_{2U2}) unterhalb der Mittelpunktschalter (S_{3U}, S_{4U}) angeordnet sind, wobei der High-Side-Schalter (S_{1U1}) oberhalb der Mittelpunktschalter (S_{3U}, S_{4U}) mit einem ersten positiven Anschluss (DC+) und der High-Side-Schalter (S_{1U2}) unterhalb der Mittelpunktschalter (S_{3U}, S_{4U}) mit einem zweiten positiven Anschluss (DC+) verbunden sind, wobei der Low-Side-Schalter (S_{2U1}) oberhalb der Mittelpunktschalter (S_{3U},. S_{4U}) mit einem ersten negativen Anschluss (DC-) und der Low-Side-Schalter (S_{2U2}) unterhalb der Mittelpunktschalter (S_{3U}, S_{4U}) mit einem zweiten negativen Anschluss (DC-) verbunden ist.

8. **Leistungsmodul** (100) nach Anspruch 7, **dadurch gekennzeichnet, dass** die Source-Anschlüsse der High-Side-Schalter (S_{1U1}, S_{1U2}) über einen metallischen Clip miteinander verbunden sind, wobei der Clip eine Doppel-T-Struktur (6) aufweist, über die der Clip den Anschluss (AC) für den Mittelabgriff, die beiden Drain-Anschlüsse der Low-Side-Schalter (S_{2U1}, S_{2U2}) und einen Anschluss der Mittelpunktschalter (S_{3U}, S_{4U}) kontaktiert.

9. Leistungsmodul nach Anspruch 7, **dadurch gekennzeichnet, dass** die Source-Anschlüsse der High-Side-Schalter jeweils über einen Clip (10, 11) mit dem Drain-Anschluss eines Low-Side-Schalters und einer Metallisierung für einen Anschluss (AC) für den Mittelabgriff verbunden sind, wobei über einen weiteren Clip (12) ein Anschluss der Mittelpunktschalter mit dem Anschluss (AC) für den Mittelabgriff verbunden ist.

10. Leistungsmodul (100) nach Anspruch 9, **dadurch gekennzeichnet, dass** der weitere Clip (12) eine Aussparung aufweist, wobei unterhalb der Aussparung ein gemeinsamer Gate-Anschluss (G_{1U}) für die High-Side-Schalter (S_{1U1}, S_{1U2}) angeordnet ist.
